# EUROPEAN PATENT APPLICATION

(11) **EP 4 439 633 A1**
(43) Date of publication of application: **02.10.2024**
(21) Application number: 23165871.7
(22) Date of filing: 31.03.2023
(51) Int. Cl.: H01L 21/329, H01L 21/332, H01L 29/06, H01L 29/861, H01L 29/744, H01L 29/417, H01L 29/66

(54) **POWER SEMICONDUCTOR DEVICE AND METHOD FOR PRODUCING A POWER SEMICONDUCTOR DEVICE**

(71) Applicant: Hitachi Energy Ltd, 8050 Zürich (CH)
(72) Inventor: VEMULAPATI, Umamaheswara, 5210 Windisch (CH); VOBECKY, Jan, 16000 Praha 6 (CZ); WIKSTROEM, Tobias, 5704 Egliswil (CH); STIASNY, Thomas, 8820 Wädenswil (CH)
(74) Representative: Epping - Hermann - Fischer

(57) **Abstract**

A power semiconductor device (1) is specified, comprising
- a first electrode (2),
- a first semiconductor layer (3) of a first conductivity type,
- a drift layer (4) of the first conductivity type,
- a second semiconductor layer (5) of a second conductivity type different from the first conductivity type, and
- a second electrode (6), wherein
- the first semiconductor layer (3) is structured by several doped regions (7) of the second conductivity type in a termination region (8) surrounding an active region (9) of the power semiconductor device (1), and
- at least one of the first semiconductor layer (3) and the second semiconductor layer (5) has a bevel structure (19).

Furthermore, a method for producing a power semiconductor device (1) is specified.

## Description

The present disclosure relates to a power semiconductor device and to a method for producing a Power semiconductor device.

Embodiments of the disclosure relate to a power semiconductor device, which has an improved performance. Further embodiments of the disclosure relate to a method for producing such a power semiconductor device.

This is achieved by the subject-matter of the independent claims. Further embodiments are evident from the dependent claims in the following description.

A power semiconductor device is described. The term "power" here and in the following, for example, refers to power semiconductor modules, power semiconductor devices and/or power semiconductor chips adapted for processing voltages and currents of more than 100 V and/or more than 10 A, exemplary voltages up to 10 kV and currents of amperes up to 10 kA.

According to an embodiment, the power semiconductor device comprises a first electrode. The first electrode extends exemplarily in lateral directions. For example, the first electrode is configured to be electrically conductively contacted externally. Exemplarily, the first electrode comprises or consists of a metal.

The first electrode can comprise a first layer and a second layer, being stacked above one another in vertical direction, which is perpendicular to the lateral directions. For example, the first layer comprises a metal which is different from a metal comprised by the second layer. The first layer comprises exemplarily molybdenum and the second layer comprises exemplarily aluminum and/or other metals like copper, titanium and/or nickel. In particular, the first layer is configured to be electrically conductively contacted externally and the second layer is a metallization. For example, the metallization is applied in a method using a sputtering process or an evaporation process.

According to the embodiment, the power semiconductor device comprises a first semiconductor layer of a first conductivity type. The first semiconductor layer extends exemplarily in lateral directions. For example, the first semiconductor layer comprises a semiconductor material or consists of a semiconductor material. Exemplarily, the semiconductor material is based on silicon. The first semiconductor layer comprises, for example, a first dopant of the first conductivity type.

According to the embodiment, the power semiconductor device comprises a drift layer of the first conductivity type. The drift layer extends exemplarily in lateral directions. For example, the drift layer comprises a semiconductor material or consists of a semiconductor material. Exemplarily, the semiconductor material comprises or consists of the same material than the first semiconductor layer. The drift layer comprises, for example, a further first dopant of the first conductivity type. The further first dopant of the drift layer is, for example, the same dopant than in the first semiconductor layer.

For example, a maximum doping concentration of the drift layer is lower than a maximum doping concentration of the first semiconductor layer. The maximum doping concentration of the drift layer is, for example, at least one order of magnitude smaller than the maximum doping concentration of the first semiconductor layer.

According to the embodiment, the power semiconductor device comprises a second semiconductor layer of a second conductivity type different from the first conductivity type. The second semiconductor layer extends exemplarily in lateral directions. For example, the second semiconductor layer comprises a semiconductor material or consists of a semiconductor material. Exemplarily, the semiconductor material comprises or consists of the same material than the first semiconductor layer. The first semiconductor layer comprises, for example, a second dopant of the second conductivity type.

Exemplarily, the first conductivity type is an n-conductivity type and the second conductivity type is a p-conductivity type or vice versa. For example, the first dopant is an n-type dopant and the second dopant is a p-type dopant or vice versa.

According to the embodiment, the power semiconductor device comprises a second electrode. The second electrode extends exemplarily in lateral directions. For example, the second electrode is configured to be electrically conductively contacted externally. Exemplarily, the second electrode comprises or consists of a metal.

The second electrode can comprise a third layer and a fourth layer, being stacked above one another in vertical direction. For example, the third layer comprises a metal which is different than a metal comprised by the fourth layer. The third layer comprises exemplarily aluminum and/or other metals like copper, titanium, nickel, tungsten, platinum and/or gold and the fourth layer comprises exemplarily molybdenum. In particular, the third layer is a metallization and the further layer is configured to be electrically conductively contacted externally.

For example, the first electrode is a cathode electrode of the power semiconductor device and the second electrode is an anode electrode of the power semiconductor device or vice versa.

The first layer and the fourth layer are, for example, not present in the power semiconductor device. The first layer and the fourth layer are, for example, provided in order to handle the power semiconductor device, wherein the first electrode solely comprises the second layer and the second electrode solely comprises the third layer.

According to the embodiment of the power semiconductor device, the first semiconductor layer is structured by several doped regions of the second conductivity type in a termination region surrounding an active region of the power semiconductor device. The termination region is a peripheral region of the power semiconductor device and the active region is a central region of the power semiconductor device.

This is the peripheral region completely surrounds the active region in lateral directions.

The active region is located at a center of mass of the power semiconductor device and extends in lateral directions in direction to at least one edge of the power semiconductor device. The termination region extends in lateral directions along an edge region of the power semiconductor device delimiting the active region.

The doped regions extend within the termination region. Exemplarily, each of the doped regions completely surround the active region in lateral directions. For example, each of the doped regions has a shape in plan view which is circular, elliptical or polygonal, such as quadrangular. In particular, the shape in plan view of the doped regions corresponds to an outer shape in plan view of the power semiconductor device, in particular the drift layer.

Exemplarily, the doped regions extend in vertical direction within the first semiconductor layer up to a predetermined depth. The predetermined depth is smaller than a height of the first semiconductor layer in vertical direction.

The doped regions comprise, exemplarily, a further second dopant. The further second dopant can be the same dopant than the second dopant.

The maximum doping concentration of the first semiconductor layer is, exemplarily, equal to or higher than a maximum doping concentration of the doped regions. Preferably, the maximum doping concentration of the first semiconductor is higher than the maximum doping concentration of the doped regions.

For example, the power semiconductor described here is a fast recovery diode, in particular a free floating discrete fast recovery diode. Furthermore, the power semiconductor described here can be a reverse conducting integrated gate-commutated thyristor, RC-IGCT. An RC-IGCTS comprises a diode part and a GCT part, wherein a separation region is arranged between the diode part and a GCT part. The diode comprises all elements described herein of the active region and the separation region is formed of all elements of the termination region.

In summary, such a power semiconductor device having a a first semiconductor layer, which is interrupted by the doped regions of a different conductivity type in the termination region, can provide, inter alia, the following advantages.

Advantageously, the doped regions reduce an emitter injection efficiency in the termination region. Due to the doped regions, the termination region of the power semiconductor device is effectively disconnected in an electrical manner from operation in the conduction (ON)-state by reducing significantly the emitter injection efficiency in the termination region. Advantageously, less heat is generated in the termination region with lower cooling capability. Thus, thermal stability is increased during frequency operation or in surge current event which enables the power semiconductor device to operate at higher temperatures.

According to a further embodiment of the power semiconductor device, the first electrode, the first semiconductor layer, the drift layer, the second semiconductor layer and the second electrode are stacked above one another along a stacking direction in vertical direction. Directly neighboring elements are, for example in direct contact to one another. Exemplarily, the first layer of the first electrode faces away from the first semiconductor layer and the second layer of the first electrode faces the first semiconductor layer. Exemplarily, the third layer of the second electrode faces the second semiconductor layer and the fourth layer of the second electrode faces away from the second semiconductor layer.

According to a further embodiment of the power semiconductor device, the first semiconductor layer comprises a first sublayer facing the first electrode and a second sublayer facing the drift layer. For example, a maximum doping concentration of the first sublayer is higher than a maximum doping concentration of the second sublayer. The maximum doping concentration of the first sublayer is, for example, at least one order of magnitude higher than the maximum doping concentration of the second sublayer.

For example, the predetermined depth of each doped region is smaller than a height of the first sublayer in vertical direction.

According to a further embodiment of the power semiconductor device, the second semiconductor layer comprises a third sublayer facing the drift layer and a fourth sublayer facing the second electrode. For example, a maximum doping concentration of the fourth sublayer is higher than a maximum doping concentration of the third sublayer. The maximum doping concentration of the fourth sublayer is, for example, at least one order of magnitude higher than the maximum doping concentration of the third sublayer. For example, the maximum doping concentration of the fourth sublayer equals a maximum doping concentration of the doped regions. Alternatively, the maximum doping concentration of the doped regions can be higher than the maximum doping concentration of the fourth sublayer.

According to a further embodiment of the power semiconductor device, one of the first electrode and the second electrode extend over the active region and the termination region. In particular only one of the first electrode and the second electrode extend over the active region and the termination region.

For example, the first electrode extends completely over the first semiconductor layer in lateral directions. In particular, the second layer of the first electrode completely covers the bottom surface of the first sublayer of the first semiconductor layer, in particular in the active region and the termination region. Exemplarily, the first layer of the first electrode covers the second layer of the first electrode only in the active region. This is that the first layer of the first electrode extends only in the active region in lateral directions.

Alternatively, the second electrode extends completely over the second semiconductor layer in lateral directions. In particular, the third layer of the second electrode completely covers the top surface of the fourth sublayer of the second semiconductor layer, in particular in the active region and the termination region. Exemplarily, the fourth layer of the second electrode covers the third layer of the second electrode in only the active region. This is that the fourth layer of the second electrode extends only in the active region in lateral directions.

According to a further embodiment of the power semiconductor device, one other of the first electrode and the second electrode extends only over the active region.

If, the first electrode extends completely over the first semiconductor layer in lateral directions, i.e. over the active region and the termination region, the second electrode only extends over the active region. In particular, the third layer and the fourth layer of the second electrode have the same extent in lateral directions.

If, the second electrode extends completely over the second semiconductor layer in lateral directions, i.e. over the active region and the termination region, the first electrode only extends over the active region. In particular, the first layer and the second layer of the first electrode have the same extent in lateral directions.

According to a further embodiment of the power semiconductor device, the fourth sublayer extends in lateral directions over the active region and the termination region. For example, the fourth sublayer overlaps in plan view with the active region and at least regionally with the termination region. If the second semiconductor layer has the bevel structure, the fourth sublayer overlaps in plan view with the termination region to at least 20 % or at least 50 %.

According to a further embodiment of the power semiconductor device, the fourth sublayer extends only over the active region. In particular, the fourth sublayer overlaps in plan view only with the active region and not with the termination region.

This advantageously reduces the emitter efficiency in the termination region further.

According to the embodiment of the power semiconductor device, at least one of the first semiconductor layer and the second semiconductor layer has a bevel structure. Exemplarily, the first semiconductor layer and the second semiconductor layer each has a bottom surface and a top surface both extending in lateral directions, where the top surface and the bottom surface is connected with at least one side surface. The side surface of at least one of the first semiconductor layer and the second semiconductor layer is inclined to the vertical direction in the termination region.

For example, the bevel structure is arranged in the termination region. In particular, the bevel structure is solely arranged in the termination region. Exemplarily, the bevel structure defines an extent of the termination region in lateral directions.

According to a further embodiment of the power semiconductor device, the third sublayer and the fourth sublayer taper towards the second electrode in the termination region. This is the bevel structure is arranged in the second semiconductor layer such that the side surface of the second semiconductor layer, formed of a side surface of the third sublayer and a side surface of the fourth sublayer, encloses an angle of less than 90° with the top surface of the drift layer.

Dependent on the angle, i.e. dependent on a steepness of the bevel structure, a junction depth can be predetermined. This is that dependent on the angle the emitter efficiency in the termination region can be preset in a precise manner.

According to a further embodiment of the power semiconductor device, the third sublayer tapers towards the second electrode in the termination region. This is, if the fourth sublayer extends only over the active region, the bevel structure is arranged in the second semiconductor layer such that the side surface of the second semiconductor layer, formed of the side surface of the third sublayer, encloses an angle of less than 90° with the top surface of the drift layer.

Advantageously, dependent on the angle the emitter efficiency in the termination region can be preset particularly precisely.

According to a further embodiment of the power semiconductor device, the first sublayer and the doped regions taper towards the first electrode in the termination region. This is, the bevel structure is arranged in the first semiconductor layer such that the side surface of the first semiconductor layer, formed of the side surface of the first sublayer, encloses an angle of less than 90° with the bottom surface of the drift layer.

Exemplarily, the height of the doped regions and the height of the first sublayer is reduced in direction from the active region to the edge of the power semiconductor device due to the bevel structure.

Additionally, the second sublayer can taper towards the first electrode in the termination region. This is, a side surface of the second sublayer, encloses a further angle of less than 90° with the bottom surface of the drift layer. The side surface of the first semiconductor layer is in particular formed of the side surface of the first sublayer and the side surface of the second sublayer. The angle is exemplarily smaller than the further angle.

According to a further embodiment of the power semiconductor device, the doped regions are spaced apart from one another in lateral directions by the first sublayer. This is that between directly neighboring doped regions, the first sublayer is arranged. Exemplarily, in plan view, the doped regions do not overlap with the first sublayer.

For example, the second sublayer directly adjoins the doped regions between two regions of the first sublayer. In particular, a height in vertical direction of the second sublayer is higher where the doped regions adjoin the second sublayer than a height of the second sublayer where the first sublayer adjoins the second sublayer.

According to a further embodiment of the power semiconductor device, the first sublayer is separated into segments in lateral directions by the doped regions. Exemplarily, the segments are spaced apart by the doped regions in lateral directions. This is that directly neighboring segments are particularly not in physical contact to one another.

For example, the segments can be embedded in the doped regions. This is that at least one outer surface or all outer surfaces of each segment is covered, in particular completely covered, by the doped regions.

Exemplarily, the segments extend within the termination region. For example, each of the segments completely surround the active region in lateral direction. This is that each of the segments has a shape in plan view which is circular, elliptical or polygonal, such as quadrangular. In particular, the shape in plan view of the segments corresponds to the outer shape in plan view of the power semiconductor device, in particular the drift layer.

This is that the emitter efficiency is advantageously reduced further.

According to a further embodiment of the power semiconductor device, each segment has a cross sectional shape being a quadrangular, a circle, an ellipse or a polygon. The polygon is, for example, a quadrangular or a hexagon. In particular, the cross sectional shape is defined perpendicular to the lateral directions.

According to a further embodiment of the power semiconductor device, the first sublayer comprises several further doped regions of the second conductivity type in the active region. The further doped regions are arranged in lateral directions from an interface of the active region and the termination region in direction to the center of mass of the power semiconductor device. For example, the further doped regions extend in lateral directions completely from the interface of the active region and the termination region to an opposite interface of the active region and the termination region.

The further doped regions extend within the active region. Exemplarily, each of the further doped regions completely surround the center of mass of the termination region. Exemplarily, each of the further doped regions has a shape in plan view corresponding to the shape of the doped regions in plan view.

The further doped regions comprise, exemplarily, the further second dopant. This is that the doped regions and the further doped regions comprise the same dopant. Exemplarily, a maximum doping concentration of the further doped regions is, exemplarily, equal to the maximum doping concentration of the doped regions.

According to a further embodiment of the power semiconductor device, the further doped regions are spaced apart from one another in lateral directions by the first sublayer. For example, the first sublayer is separated into further segments in lateral directions by the further doped regions in the active region. Exemplarily, the further segments are spaced apart by the further doped regions in lateral directions. This is that directly neighboring further segments are in particular not in physical contact to one another.

For example, the further segments can be embedded in the further doped regions. This is that at least one outer surface or all outer surfaces of each further segment is covered, in particular completely covered, by the further doped regions. Each further segment has, for example, a cross sectional shape corresponding to the segments.

Exemplarily, the further doped regions extend from the bottom surface, which faces the first electrode, of the first semiconductor layer in vertical direction in the first semiconductor layer up to a further predetermined depth. The further predetermined depth is smaller than a height of the first semiconductor layer, in particular the first sublayer, in vertical direction.

According to a further embodiment of the power semiconductor device, a width in lateral directions of each of the doped regions is equal to a further width of at least some of the further doped regions. The width and the further width correspond to a minimal extent of each of the doped regions and further doped regions in lateral directions, respectively.

If the further doped regions extend in lateral directions from the termination region in the active region up to an extension distance, each width of the doped regions are equal to each further width of the further doped regions.

If the further doped regions extend in lateral directions from the interface up to a further distance being larger than the extension distance, each width of the doped regions are equal to each further width of the further doped regions in the extension distance and each width of the doped regions is different than each further width of the further doped regions not located within the extension distance.

If the further segments extend in lateral directions from the termination region in the active region up to the extension distance, each width of the segments are equal to each further width of the further segments.

If the further doped segments extend in lateral directions from the interface up to a further distance being larger than the extension distance, each width of the segments are equal to each further width of the further segments in the extension distance and each width of the segments is different than each further width of the further segments not located within the extension distance.

According to a further embodiment of the power semiconductor device, a width in lateral directions of each of the doped regions is smaller than a further width of at least some of the further doped regions.

If the further doped regions extend in lateral directions from the interface up to the further distance, each width of the doped regions are equal to each further width of the further doped regions in the extension distance and each width of the doped regions is smaller than each further width of the further doped regions not located within the extension distance.

Alternatively, each width of the doped regions is smaller to each further width of the further doped regions in the active region.

If the further segments extend in lateral directions from the interface up to the further distance, each width of the segments are equal to each further width of the further segments in the extension distance and each width of the segments is smaller than each further width of the further segments not located within the extension distance.

Alternatively, each width of the segments is smaller to each further width of the further segments in the active region.

The widths of the doped regions can define a width of the segments. Further, the further widths of the further doped regions can define a further width of the further segments. Further, the width of the segments and/or the width of the further segments is dependent on a number of the doped regions and/or the further doped regions. A number of the doped regions can be the same or different to a number of segments and/or a number of the further doped regions can be the same or different to a number of the further segments.

For example, at least one of the segments and the further segments have a width of at least 30 µm and at most 300 pm, in particular at least 100 µm and at most 200 µm. Exemplary, at least one of directly neighboring segments and directly neighboring further segments have a distance to one another in lateral directions of at least 30 µm and at most 400 µm, in particular at least 100 µm and at most 200 µm. The distance corresponds to at least one of the width of the doped regions and the further width of the further doped regions.

According to a further embodiment of the power semiconductor device, the further doped regions extend in lateral directions from the termination region in the active region up to an extension distance. In particular, the further doped regions extend in lateral directions from the interface between the termination region and the active region up to the extension distance in the active region in lateral directions.

According to a further embodiment of the power semiconductor device, the extension distance is at least 1 and at most 7 times a height in vertical direction of the drift layer. In particular, the extension distance is at least 3 and at most 5 times the height of the drift layer.

With such an extension distance, the emitter efficiency is advantageously reduced at the interface between the termination region in the active region.

According to a further embodiment, the power semiconductor device comprises a passivation. The passivation encapsulates the layers of the power semiconductor device, for example. The first electrode and the second electrode are, in particular, partially free of the passivation. Exemplarily, the first layer of the first electrode and the fourth layer of the second electrode are free of the passivation.

The passivation comprises an electrically insulating material, such as a dielectric material. For example, the passivation material comprises a semi-insulating material at silicon surface. Beside the insulation of semiconductor surface from surroundings, the role of such material is the drainage of leakage current to one of electrodes, especially at elevated temperatures.

According to a further embodiment of the power semiconductor device, the first electrode, the first semiconductor layer, the drift layer, the second semiconductor layer and the second electrode are surrounded by the passivation in the termination region. For example, side surfaces of the layers and the electrodes are completely covered by the passivation.

Exemplarily, the bevel structure is completely embedded in the passivation. This is that the side surface, which forms the bevel structure, is completely covered with the passivation.

Advantageously, the power semiconductor device is protected from an environment due to the passivation.

According to a further embodiment of the power semiconductor device, an oxide layer extending in the active region is arranged on at least one of the first semiconductor layer and the second semiconductor layer.

The oxide layer extends within the active region, in particular from the termination region in direction to the center of mass. Exemplarily, the oxide layer has a shape in plan view which is circular, elliptical or polygonal, such as quadrangular. In particular, the shape in plan view of the oxide layer corresponds to the outer shape in plan view of the power semiconductor device, in particular the drift layer.

For example, the oxide layer is arranged on the semiconductor layer not having the doped regions. If the first semiconductor layer comprises the doped regions, the oxide layer is arranged on the second semiconductor layer. If the second semiconductor layer comprises the doped regions, the oxide layer is arranged on the first semiconductor layer.

If, the oxide layer is arranged on the first sublayer, the oxide layer faces the first electrode. If, the oxide layer is arranged on the fourth sublayer, the oxide layer faces the second electrode.

With the oxide layer, in particular a combination of the oxide layer and the doped regions, the emitter efficiency can be predetermined and reduced in particular precisely.

Furthermore, a method for producing a power semiconductor device is described here, with which a power semiconductor device as described herein above can be produced or is produced. Therefore, the features in connection with the power semiconductor device are disclosed also in connection with the method and vice versa.

According to an embodiment of the method, a semiconductor material is provided with a drift layer. Exemplarily, the semiconductor material is based on silicon. The semiconductor material is provided, in particular, as a wafer.

Exemplarily, the drift layer of a first conductivity type is produced during silicon ingot pulling. In other words, it is present in the starting silicon wafer prior to production.

According to the embodiment of the method, a first semiconductor layer of the first conductivity type is produced in the drift layer from a first side. Exemplarily, the first dopant is incorporated in the wafer, e.g. the drift layer from the first side, e.g. by at least one of an ion implantation or a deposition process, which may be followed by a diffusion process.

According to the embodiment of the method, a second semiconductor layer of a second conductivity type different of the first conductivity type is produced in the drift layer from a second side opposite the first side. Exemplarily, the second dopant is incorporated in the wafer, e.g. the drift layer from the second side, e.g. by at least one of an ion implantation or a deposition process, which may be followed by a diffusion process.

According to the embodiment of the method, a bevel structure is produced in at least one of the first semiconductor layer and the second semiconductor layer in a termination region surrounding an active region of the power semiconductor device.

According to the embodiment of the method, the first semiconductor layer is structured such that the first semiconductor layer has several doped regions of the second conductivity type in the termination region.

According to a further embodiment of the method, the bevel structure is produced by a grinding process.

According to a further embodiment of the method, the doped regions are produced by an implantation process. For example, the doped regions are produced from a first side. Exemplarily, the further second dopants are incorporated in the wafer with by employing a mask.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.

Figures 1 to 6 each is a cross sectional view of a power semiconductor device according to an exemplary embodiment, and

Figure 7 is a schematic plan view of a power semiconductor device according to an exemplary embodiment.

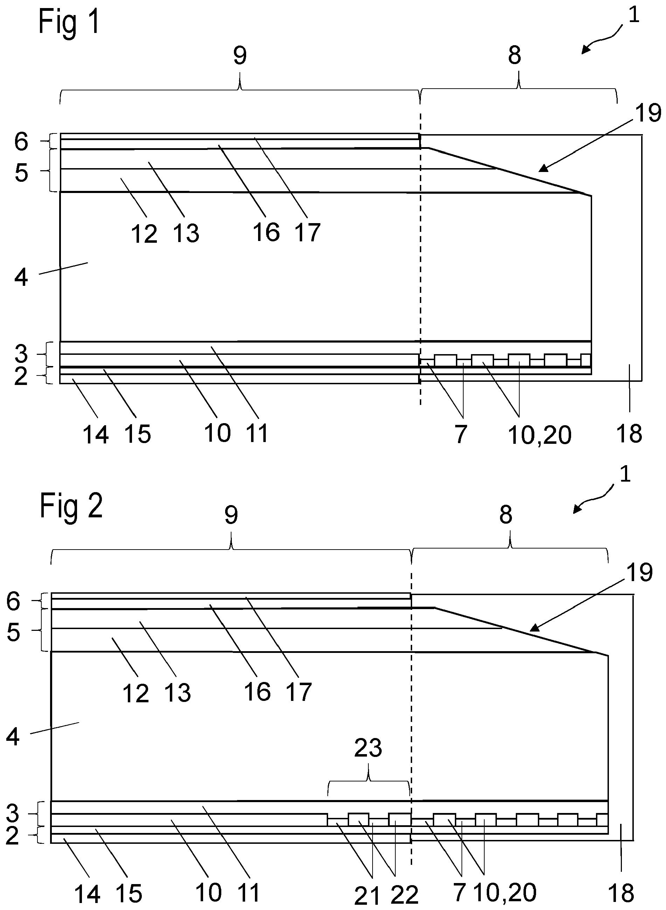

The power semiconductor device 1 according to the exemplary embodiment of Figure 1 comprises a first electrode 2 comprising a first layer 14 and a second layer 15 as well as a second electrode 6 comprising a third layer 16 and a fourth layer 17. The power semiconductor device 1 further comprises a first semiconductor layer 3 of a first conductivity type comprising a first sublayer 10 and a second sublayer 11 as well as a second semiconductor layer 5 of a second conductivity type comprising a third sublayer 12 and a fourth sublayer 13. Further, the power semiconductor device 1 comprises a drift layer 4.

The first electrode 2, in particular the first layer 14 and the second layer 15, the first semiconductor layer 3, in particular the first sublayer 10 and the second sublayer 11, the drift layer 4, the second semiconductor layer 5, in particular the third sublayer 12 and the fourth sublayer 13 and the second electrode 6, in particular the third layer 16 and the fourth layer 17, are stacked above one another in a stacking direction corresponding to a vertical direction. Each of the layers extend in lateral directions being perpendicular to the vertical direction. Further, each of the layers are in direct contact to one another. Bottom surfaces of the layers face the first electrode 2 and top surfaces of the layers face the second electrode 6.

The second layer 15 of the first electrode 2 completely covers a bottom surface of the first sublayer 10 of the first semiconductor layer 3. The first layer 14 of the first electrode 2 completely covers a bottom surface of the second layer 15 only in an active region 9 of the power semiconductor device 1. This is that the first layer 14 completely overlaps with the active region 9 in lateral directions in plan view, in particular congruently.

In particular, the plan view is a view in vertical direction on the top surfaces of the elements of the power semiconductor device 1.

The active region 9 is located at and extends in lateral directions around a center of mass of the power semiconductor device 1. Figure 1 shows only one half of the power semiconductor device 1. Exemplarily, the left edge in Figure 1 comprises the center of mass.

A termination region 8 extends in lateral directions along an edge region of the power semiconductor device 1 delimiting the active region 9. The termination region 8 is free of the first layer 14 of the first electrode 2. This is that the first layer 14 does not overlap with the termination region 8 in lateral directions in plan view.

The third layer 16 of the second electrode 6 completely covers a top surface of the fourth sublayer 13 of the second semiconductor layer 5 only in the active region 9. The fourth layer 17 of the second electrode 6 completely covers a top surface of the third layer 16. This is that the third layer 16 and the fourth layer 17 each completely overlaps with the active region 9 in lateral directions in plan view, in particular congruently.

The termination region 8 is free of the third layer 16 and the fourth layer 17 of the second electrode 6. This is that the third layer 16 and the fourth layer 17 each do not overlap with the termination region 8 in lateral directions in plan view.

The second semiconductor layer 5 has a bevel structure 19 in the termination region 8. A side surface of the second semiconductor layer 5, connecting the top surface and the bottom surface of the second semiconductor layer 5, is inclined to the vertical direction. The side surface of the second semiconductor layer 5 is only inclined in the termination region 8. An angle between the side surface of the second semiconductor layer 5 and the bottom surface of the second semiconductor layer 5 is smaller than 90°, in particular smaller than 45°. This is that the third sublayer 12 and the fourth sublayer 13 taper towards the second electrode 6 in the termination region 8.

The first sublayer 10 of the first semiconductor layer 3 is structured by several doped regions 7 of the second conductivity type in the termination region 8. This is the first sublayer 10 is structured and separated into segments 20 by the doped regions 7. Between directly neighboring segments, one of the doped regions 7 is arranged in lateral directions. The doped regions 7 and the segments 20 are arranged alternating in lateral directions from an interface of the active region 9 and the termination region 8 to the edge of the power semiconductor device 1. The alternating sequence starts from the interface with one of the doped regions 7. This is that the segments 20 are spaced apart from the first sublayer 10 in the active region 9 by the doped region. Directly neighboring doped regions 7 and segments 20 are direct contact to one another.

The doped regions 7 have a width, which defines a spacing of the segments 20 in lateral directions. The width of each doped region is the same and the width of each segment 20 is the same.

The bottom surface of the first sublayer 10 and the segments 20 as well as the bottom surface of the doped regions 7 terminate flush with one another and extend in a common plane. The doped regions 7 extend from the bottom surfaces in vertical direction up to a predetermined depth. The predetermined depth is smaller than a height of the first semiconductor layer 3 in vertical direction.

The doped regions 7 completely overlap with the second sublayer 11 in plan view. Further, the doped regions 7 do not overlap with the first sublayer 10, in particular the segments 20, in plan view. This is that top surfaces of the doped regions 7 are completely covered with the second sublayer 11, which completely extends between the segments 20 up to the doped regions 7.

The power semiconductor device 1 further comprises a passivation 18. The passivation 18 encapsulates the layers of the power semiconductor device 1, wherein the first electrode 2 and the second electrode 6 are, in particular, partially free of the passivation 18.

In addition to the exemplary embodiment of Figure 1, the first sublayer 10 of the first semiconductor layer 3 is structured by several further doped regions 21 in the active region 9 according to the exemplary embodiment of Figure 2. This is the first sublayer 10 is structured and separated into further segments 22 by the further doped regions 21 in the active region 9.

Between directly neighboring further segments 22, one of the further doped regions 21 is arranged in lateral directions. The further doped regions 21 and the further segments 22 are arranged alternating in lateral directions from the interface to the center of mass of the power semiconductor device 1. The alternating sequence starts from the interface with one of the further segments 22. Directly neighboring further doped regions 21 and further segments 22 are direct contact to one another.

The further doped regions 21 have a width, which defines a spacing of the further segments 22 as well as a further width of the segments 20 in lateral directions.

The bottom surface of the first sublayer 10 and the segments 20 as well as the bottom surface of the further doped regions 21 terminate flush with one another and extend in a common plane. The further doped regions 21 extend form the bottom surfaces in vertical direction up to a further predetermined depth. The further predetermined depth is smaller than a height of the first semiconductor layer 3 in vertical direction and is equal to the predetermined depth.

The further doped regions 21 completely overlap with the second sublayer 11 in plan view. Further, the further doped regions 21 do not overlap with the first sublayer 10, in particular the further segments 22, in plan view. This is that top surfaces of the further doped regions 21 are completely covered with the second sublayer 11, which completely extends between the further segments 22 up to the further doped regions 21.

Alternatively, it is conceivable that the segments 20 and/or the further segments 22 are embedded in the doped regions 7 and/or in the further doped regions 21. In this case, the doped regions 7 and/or in the further doped regions 21 are formed continuously, wherein the doped regions 7 and/or in the further doped regions 21 completely cover an outer surface of each of the segments 20 and/or the further segments 22. In this case, the doped regions 7 and/or in the further doped regions 21 completely overlap in plan view with the first sublayer 10, i.e. the segments 20 and/or the further segments 22.

The further doped regions 21 extend in lateral directions from the interface of the active region 9 and the termination region 8 in the active region 9 up to an extension distance 23. The extension distance 23 is at least 1 and at most 7 times a height in vertical direction of the drift layer 4.

The width of each doped region is the same and the width of each further doped region is the same. Further, the width of each segment is the same and the width of each further segment is the same.

In this embodiment, the width of the segments 20 is equal to the width of the further segments 22. Further, the width of the doped regions 7 is equal to the width of the further doped regions 21.

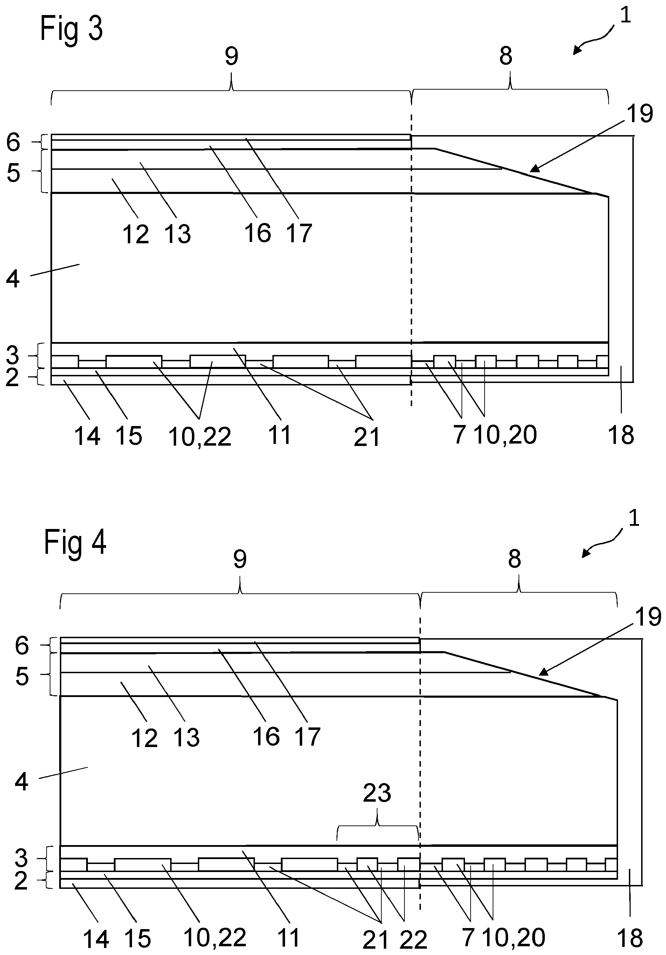

In contrast to the exemplary embodiment of Figure 2, the first sublayer 10 of the first semiconductor layer 3 is completely structured by several further doped regions 21 in the active region 9 according to the exemplary embodiment of Figure 3. This is that the first sublayer 10 is structured and separated into further segments 22 by the further doped regions 21 in the active region 9, wherein the further doped regions 21 and the further segments 22 extend over the whole active region 9.

In this embodiment, the width of the segments 20 is smaller than the width of the further segments 22. Further, the width of the doped regions 7 is smaller than the width of the further doped regions 21.

The widths of the further segments 22 according to the exemplary embodiment of Figure 4 are in contrast to Figure 3 not the same for all further segments 22.

In this embodiment, the width of the segments 20 is equal to the width of the further segments 22 in the extension distance 23. Further, the width of the doped regions 7 is equal to the width of the further doped regions 21 in the extension distance 23. In the rest of the active region 9 excluding the extension distance 23, the width of the segments 20 is smaller than the width of the further segments 22. Further, in the rest of the active region 9 excluding the extension distance 23, the width of the doped regions 7 is smaller than the width of the further doped regions 21.

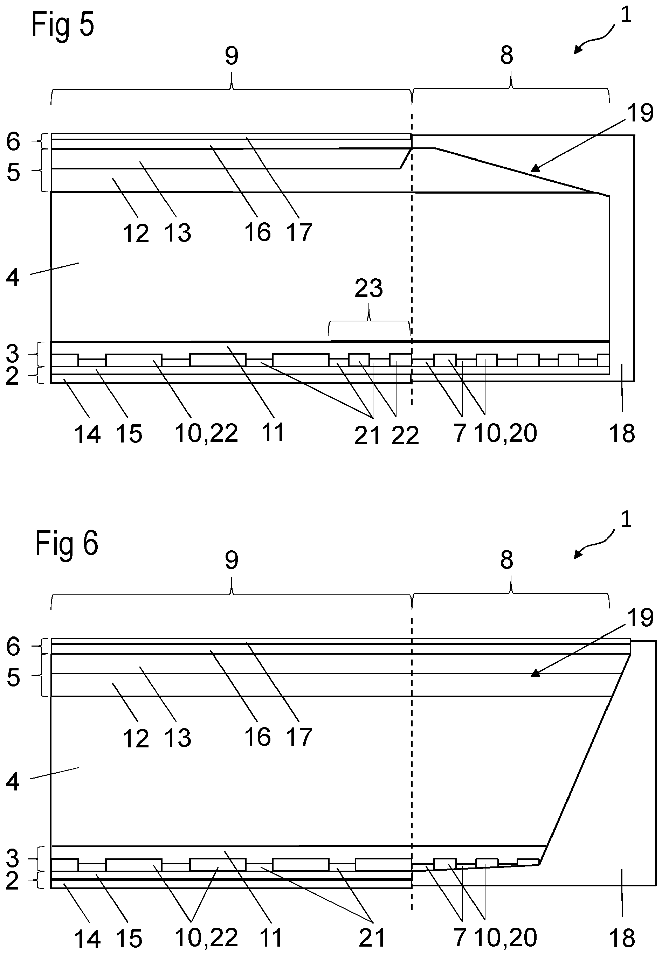

The fourth sublayer 13 according to the exemplary embodiment of Figure 5 extends in contrast to Figures 1 to 4 only over the active region 9. In plan view, the fourth sublayer 13 does not overlap with the termination region 8.

The bevel structure 19 is arranged according to the exemplary embodiment of Figure 6 in contrast to Figures 1 to 5 in the first semiconductor layer 3.

A side surface of the first semiconductor layer 3, connecting the top surface and the bottom surface of the first semiconductor layer 3, in particular a side surface of the first sublayer 10, is inclined to the vertical direction. The side surface of the first sublayer 10 is only inclined in the termination region 8. An angle between the side surface of the first sublayer 10 and the top surface of the first semiconductor layer 3 is smaller than 90°, in particular smaller than 45°. This is that the first sublayer 10 tapers towards the first electrode 2 in the termination region 8. The bottom surfaces of the doped regions 7 and the segments 20 are formed by the side surface of the first sublayer 10. As the side surface of the first sublayer 10 inclines, the heights of the doped regions 7 and the segments 20 in vertical direction reduces from the interface to the passivation 18.

A side surface being formed of a side surface of the second sublayer 11, a side surface of the drift layer 4 and a side surface of the second semiconductor layer 5 are in a common plane. The common plane is inclined to the vertical direction as well as inclined to the side surface of the first sublayer 10.

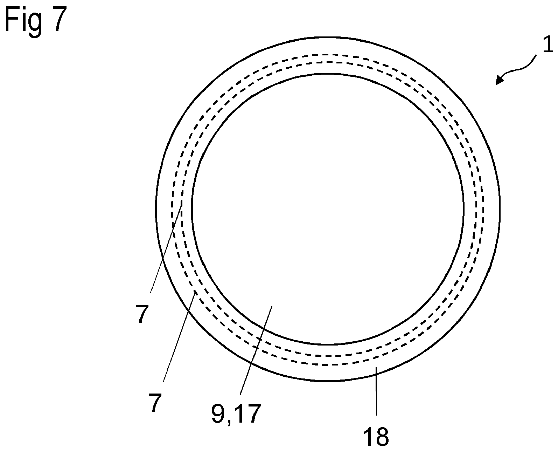

The power semiconductor device 1 according to the exemplary embodiment of Figure 7 is a plan view of one of the power semiconductor devices 1 according to one of the Figures 1 to 6. In plan view, the top surface of the fourth layer 17 and the passivation 18 is freely accessible. An outer shape of the power semiconductor device 1 is circular.

The doped regions 7 are not visible in this view such that they are indicated as dashed lines. The doped regions 7 extend within the termination region 8, wherein each of the doped regions 7 completely surround the active region 9 in lateral directions. In particular each of the doped regions 7 has a circular shape in plan view corresponding to the outer shape in plan view of the power semiconductor device 1.

### Reference Signs

- 1: power semiconductor device
- 2: first electrode
- 3: first semiconductor layer
- 4: drift layer
- 5: second semiconductor layer
- 6: second electrode
- 7: doped regions
- 8: termination region
- 9: active region
- 10: first sublayer
- 11: second sublayer
- 12: third sublayer
- 13: fourth sublayer
- 14: first layer
- 15: second layer
- 16: third layer
- 17: fourth layer
- 18: passivation
- 19: bevel structure
- 20: segment
- 21: further doped region
- 22: further segment
- 23: extension distance

## Claims

1. Power semiconductor device (1), comprising
- a first electrode (2),
- a first semiconductor layer (3) of a first conductivity type,
- a drift layer (4) of the first conductivity type,
- a second semiconductor layer (5) of a second conductivity type different from the first conductivity type, and
- a second electrode (6), wherein
- the first semiconductor layer (3) is structured by several doped regions (7) of the second conductivity type in a termination region (8) surrounding an active region (9) of the power semiconductor device (1).

2. Power semiconductor device (1) according to claim 1, wherein
- the first electrode (2), the first semiconductor layer (3), the drift layer (4), the second semiconductor layer (5) and the second electrode (6) are stacked above one another along a stacking direction in vertical direction.

3. Power semiconductor device (1) according to one of the claims 1 or 2, wherein
- the first semiconductor layer (3) comprises a first sublayer (10) facing the first electrode (2) and a second sublayer (11) facing the drift layer (4), and
- the second semiconductor layer (5) comprises a third sublayer (12) facing the drift layer (4) and a fourth sublayer facing (13) the second electrode (6).

4. Power semiconductor device (1) according to claim 1 to 3, wherein
- one of the first electrode (2) and the second electrode (6) extends over the active region (9) and the termination region (8), and
- one other of the first electrode (2) and the second electrode (6) extends only over the active region (9).

5. Power semiconductor device (1) according to one of the claims 3 or 4, wherein
- the fourth sublayer (13) extends in lateral directions over the active region (9) and the termination region (8), or
- the fourth sublayer (13) extends only over the active region (9).

6. Power semiconductor device (1) according to one of the claims 3 to 5, wherein
- at least one of the first semiconductor layer (3) and the second semiconductor layer (5) has a bevel structure (19),
- the third sublayer (12) and the fourth sublayer (13) taper towards the second electrode (6) in the termination region (8),
- only the third sublayer (12) tapers towards the second electrode (6)
in the termination region (8), or
- the first sublayer (10) and the doped regions (7) taper towards the first electrode (2) in the termination region (8) .

7. Power semiconductor device (1) according to one of the claims 1 to 6, wherein
- the doped regions (7) are spaced apart from one another in lateral directions by the first sublayer (10).

8. Power semiconductor device (1) according to one of the claims 1 to 7, wherein
- the first sublayer (10) is separated into segments (20) in lateral directions by the doped regions (7), and
- each segment (20) has a cross sectional shape being a quadrangular, a circle, an ellipse or a polygon.

9. Power semiconductor device (1) according to one of the claims 1 to 8, wherein
- the first sublayer (10) comprises several further doped regions (21) of the second conductivity type in the active region (9), and
- the further doped regions (21) are spaced apart from one another in lateral directions by the first sublayer (10).

10. Power semiconductor device (1) according to claim 9, wherein at least one of
- a width in lateral directions of each of the doped regions (7) is the same than a further width of at least some of the further doped regions (21), and
- a width in lateral directions of each of the doped regions (7) is smaller than a further width of at least some of the further doped regions (21).

11. Power semiconductor device (1) according to one of the claims 9 or 10, wherein
- the further doped regions (21) extend in lateral directions from the termination region (8) in the active region (9) up to an extension distance (23), and
- the extension distance (23) is at least 1 and at most 7 times a height in vertical direction of the drift layer (4).

12. Power semiconductor device (1) according to one of the claims 1 to 11, further comprises
- a passivation (18), wherein
- the first electrode (2), the first semiconductor layer (3), the drift layer (4), the second semiconductor layer (5) and the second electrode (6) are surrounded by the passivation (18) in the termination region (8).

13. Power semiconductor device (1) according to one of the claims 1 to 12, wherein
- at least one of the first semiconductor layer (3) and the second semiconductor layer (5) comprises an oxide layer extending in the active region (9).

14. Method for producing a semiconductor device, comprising
- providing a semiconductor material with a drift layer (4) of a first conductivity type,
- producing a first semiconductor layer (3) of the first conductivity type in the drift layer (4) from a first side,
- producing a second semiconductor layer (5) of a second conductivity type different of the first conductivity type in the drift layer (4) from a second side opposite the first side,
- producing a bevel structure (19) in at least one of the first semiconductor layer (3) and the second semiconductor layer (5) in a termination region (8) surrounding an active region (9) of the power semiconductor device (1), and
- structuring the first semiconductor layer (3) such that the first semiconductor layer (3) has several doped regions (7) of the second conductivity type in the termination region (8) .

15. Method according to claim 14, wherein at least one of
- the bevel structure (19) is produced by a grinding process, and
- the doped regions (7) are produced by an implantation process.
